# EUROPÄISCHE PATENTANMELDUNG

(11) **EP 1 650 793 A1**
(43) Veröffentlichungstag der Anmeldung: **26.04.2006**
(21) Anmeldenummer: 05022316.3
(22) Anmeldetag: 13.10.2005
(51) Int. Cl.: H01L 21/74, H01L 21/225, H01L 21/265

(54) **Halbleitergegenstand und Verfahren zur Herstellung**

(30) Priorität: 19.10.2004 DE 102004050740
(71) Anmelder: ATMEL Germany GmbH, 74072 Heilbronn (DE)
(72) Erfinder: Bromberger, Christoph, Dipl.-Phys., 74074 Heilbronn (DE)

(57) **Zusammenfassung**

Verfahren zur Herstellung eines Halbleitergegenstandes, indem
- eine Silizidschicht (2) aufgebracht wird,
- in die Silizidschicht (2) ein Fremdstoff eingebracht wird, der in einem Halbleitergebiet (3) als Dotand wirkt,
- die Silizidschicht (2) zumindest teilweise unterhalb des, an die Silizidschicht angrenzenden, monokristallinen Halbleitergebietes (3) angeordnet wird, so dass die Silizidschicht (2) unter einer Schicht aus dem monokristallinen Halbleitergebiet (3) zumindest teilweise vergraben wird,
   und
- mittels eines späteren Hochtemperaturschrittes der als Dotand wirkende Fremdstoff zumindest teilweise in das angrenzende monokristalline Halbleitergebiet (3) aus der zumindest teilweise vergrabenen Silizidschicht (2) eindiffundiert wird.

## Beschreibung

Die vorliegende Erfindung betrifft einen Halbleitergegenstand und ein Verfahren zur Herstellung des Halbleitergegenstandes.

Ein Verfahren zur Herstellung vergrabener Bereiche ist aus der Druckschrift DE 101 24 038 A1 bekannt. Hierbei weist ein SOI-Wafer einen Träger aus Silizium auf, an den sich eine Oxidschicht als isolierende Schicht, deren Dicke zwischen 0,1 µm und 2,0 µm liegt, anschließt. An die Oxidschicht schließt sich eine Schicht aus Silizium an, die mittels einer Implantation in einen ersten Bereich mit einer ersten Leitfähigkeit und einen zweiten Bereich mit einer zweiten Leitfähigkeit aufgeteilt ist. In einem nachfolgenden Schritt wird auf der Oberfläche des SOI-Wafers eine ganzflächige Oxidschicht aufgebracht in der mittels eines Maskenschrittes Öffnungen geätzt werden in denen durch einen nachfolgenden Prozessschritt ein Silizid erzeugt wird. Die Dicke der Oxidschicht wird dabei so gewählt, dass sie zusammen mit den silizidierten Bereichen eine planare Oberfläche bildet. Anschließend wird eine zweite Oxidschicht aufgebracht und ein zweiter Trägerwafer auf die zweite Oxidschicht gebondet. Hiernach werden der erste Trägerwafer und die erste Oxidschicht entfernt.

Der Bahnwiderstand zum Anschluss eines monokristallinen Halbleiterbereichs nach DE 101 24 038 A1 enthält neben einem Schichtwiderstand des vergrabenen Silizidbereiches einen Übergangswiderstand zwischen dem vergrabenen Silizidbereich und dem monokristallinen Halbleiterbereich. Der Übergang vom vergrabenen Silizidbereich zu dem monokristallinen Halbleiterbereich ist hierbei bei niedrigen und gemäßigt hohen Dotandenkonzentrationen im monokristallinen Halbleiterbereich an der Grenzfläche zum vergrabenen Silizidbereich als hochohmiger, so genannter Schottky-Kontakt, ausgebildet, und nur bei hohen bis sehr hohen Dotandenkonzentration vom niederresistiven, so genannten Ohm'schen Typ.

Es ist nun, namentlich aufgrund nachteilig hoher Ausdiffusion aus hochdotierten Halbleiterbereichen bei Temperaturbeaufschlagung, nicht immer günstig, den monokristallinen Halbleiterbereich bereits bei dessen Aufbringung mit einer hoher Dotierstoffkonzentration an der Grenze zur vergrabenen Silizidschicht zu versehen. Genauso ist es, aufgrund der relativ breiten, gauß'schen Streuung von durch tiefe Implantation eingebrachten Dotanden, häufig nachteilig, eine hohe Dotandenkonzentration im monokristallinen Halbleiterbereich an der Grenzfläche zum vergrabenen Silizidbereich durch Implantation in den monokristallinen Halbleiterbereich zu erzeugen.

Die Möglichkeiten nach dem Stand der Technik, den Übergangswiderstand zwischen einer vergrabenen Silizidschicht und einem an die vergrabene Silizidschicht angrenzenden Halbleiterbereich ohm'sch auszugestalten, schränken daher den Gestaltungsspielraum der Prozessführung bei der Herstellung eines Halbleitergegenstandes stark ein.

Aufgabe der vorliegenden Erfindung ist die Angabe eines Verfahrens, den Übergangswiderstand zwischen einem vergrabenen Silizidbereich und einem monokristallinen Halbleiterbereich ohm'sch auszugestalten, welches die Nachteile des Standes der Technik möglichst reduziert.

Die Erfindung wird durch das Verfahren mit den Merkmalen des Patentanspruchs 1, durch die Verwendung mit den Merkmalen des Patentanspruchs 14, durch den Halbleitergegenstand mit den Merkmalen des Patentanspruchs 15 und durch den Hochfrequenzbipolartransistor mit den Merkmalen des Patentspruchs 24 gelöst. Vorteilhafte Weiterbildungen der Erfindung sind Gegenstand von Unteransprüchen.

Demgemäß ist ein Verfahren zur Herstellung eines Halbleitergegenstandes vorgesehen. In diesem Verfahren wird eine Silizidschicht aufgebracht und in die Silizidschicht wird einer oder mehrere Fremdstoffe eingebracht, die, nachdem diese in angrenzende Halbleitergebiete eindiffundiert wurden, dort als Dotanden wirken. Derartige Fremdstoffe sind demnach vorzugsweise die für den Siliziumhalbleiter nutzbaren Dotanden, wie beispielsweise Bor, Arsen, Phosphor, etc.. Im Silizid sind die Atome, die später ins Silizium diffundieren, und dort einen Dotierstoff darstellen, daher Fremdstoffe.

Die Silizidschicht wird zumindest teilweise unterhalb eines, an die Silizidschicht angrenzenden, monokristallinen Halbleitergebietes angeordnet. Die Anordnung erfolgt dabei derart, dass die Silizidschicht unter einer Schicht aus dem monokristallinen Halbleitergebiet zumindest teilweise vergraben wird. Mittels eines späteren Hochtemperaturschrittes werden der eine oder mehrere als Dotanden wirkende Fremdstoffe zumindest teilweise in das angrenzende monokristalline Halbleitergebiet aus der zumindest teilweise vergrabenen Silizidschicht eindiffundiert.

In diesem Verfahren zur Herstellung des Halbleitergegenstandes dient daher die mit zumindest einem Fremdstoff versehene Silizidschicht als Festkörperquelle für die Dotierung des die Silizidschicht bedeckenden monokristallinen Halbleitergebietes, wo dieser Fremdstoff als Dotierstoff wirkt. Dabei grenzt das zu dotierende monokristalline Halbleitergebiet an die Silizidschicht an.

Dabei können zwei nachfolgend erörterte Weiterbildungsvarianten der Erfindung genutzt werden. In der ersten Weiterbildungsvariante der Erfindung wird die Silizidschicht aufgebracht und zumindest ein Bereich der Silizidschicht unter das zuvor strukturierte, monokristalline Halbleitergebiet eingebracht. In einem späteren Hochtemperaturschritt werden der eine oder mehrere im Halbleitermaterial als Dotanden wirkende Fremdstoffe zumindest teilweise in das angrenzende monokristalline Halbleitergebiet aus der vergrabenen Silizidschicht eindiffundiert.

In der zweiten Weiterbildungsvariante der Erfindung wird hingegen die Silizidschicht aufgebracht und diese zumindest teilweise durch das nachfolgend aufgebrachte, monokristalline Halbleitergebiet derart bedeckt, dass die Silizidschicht unter einer Schicht aus dem monokristallinen Halbleitergebiet zumindest teilweise vergraben wird. In einem späteren Hochtemperaturschritt werden wiederum der eine oder mehrere im Halbleitermaterial als Dotanden wirkende Fremdstoffe zumindest teilweise in das angrenzende monokristalline Halbleitergebiet aus der vergrabenen Silizidschicht eindiffundiert.

Ein Verfahrensschritt einer Weiterbildung der Erfindung ist, dass in diese Silizidschicht einer oder mehrere im Halbleitermaterial als Dotanden wirkende Fremdstoffe eingebracht werden. Dotanden für einen Siliziumhalbleiter können beispielsweise Boratome, Phosphoratome, Arsenatome oder Antimonatome sein. Die Silizidschicht wird unter einer Schicht vorzugsweise vollständig vergraben. Vorzugsweise besteht diese Schicht aus dem monokristallinen Halbleitergebiet, das an die Silizidschicht angrenzt.

Bevorzugt werden diese Verfahrensschritte in der genannten Reihenfolge durchgeführt, wobei zwischen den einzelnen Prozessschritten weitere Verfahrensschritte, beispielsweise der einer Implantation oder der einer Planarisierung erfolgen können. Unter der vergrabenen Silizidschicht wird im folgenden verstanden, dass diese Silizidschicht bezogen auf die Waferoberfläche zumindest teilweise unterhalb zumindest eines aktiven, monokristallinen Halbleitergebietes eines Halbleiterbauelementes angeordnet ist. In einem nachfolgenden Hochtemperaturschritt werden die Dotanden zumindest teilweise in das angrenzende monokristalline Halbleitergebiet (aus der vergrabenen Silizidschicht) eindiffundiert.

Das Wesen der Erfindung besteht daher in der Verwendung einer Silizidschicht als Dotandenquelle, wobei wesentlich ist, dass diese Silizidschicht bereits während der Diffusion der Dotanden vorteilhafterweise teilweise, vorzugsweise vollständig vergraben ist. Demnach wird die vergrabene Silizidschicht verwendet, die zu diesem Zweck mit Fremdstoffen versehen ist, als Festkörperquelle für die Dotierung von dem an die Silizidschicht angrenzenden Halbleitergebiet. Bevorzugt ist das Halbleitergebiet, welches die Silizidschicht zumindest teilweise bedeckt, bezüglich der Waferoberfläche vollständig oberhalb der Silizidschicht angeordnet.

Eine bevorzugte Ausgestaltung der Erfindung sieht vor, dass in einem an die Silizidschicht angrenzenden Grenzbereich des monokristallinen Halbleitergebiets die Dotanden derart eindiffundiert werden, dass ein Übergangswiderstand zwischen dem monokristallinen Halbleitergebiet und der Silizidschicht ohmsch ausgebildet wird. Unter einem ohmschen Übergangswiderstand wird dabei verstanden, dass die den Übergangswiderstand passierenden Ladungsträger keine signifikante Potentialbarriere überwinden müssen.

Weiterhin ist bevorzugt vorgesehen, dass in das Grenzgebiet eine maximale Dotierstoffkonzentration von mindestens 1 · 10²⁰cm⁻³ eindiffundiert wird. Um für die gewünschte Ausdiffusion die Silizidschicht mit den später als Dotanden wirkenden Fremdstoffen zu versehen, sind unterschiedliche Ausgestaltungsvarianten der Erfindung vorgesehen, die lokal, beispielsweise in Abhängigkeit von einer entsprechenden Maskierung auch miteinander kombiniert werden können.

Eine erste Ausgestaltungsvariante sieht vor, dass die Fremdstoffe in die Silizidschicht implantiert werden. Dies kann beispielsweise nach einer Silizidierung einer Schicht einer Siliziumhalbleiteroberfläche erfolgen.

In einer zweiten Ausgestaltungsvariante erfolgen das Einbringen der Fremdstoffe und das Aufbringen der Silizidschicht mittels gleichzeitigem Sputtern eines Dotierstofftargets und eines Silizidtargets. Auch ist es in einer dritten Ausgestaltungsvariante das Einbringen der Fremdstoffe und das Aufbringen der Silizidschicht mittels Sputtern eines mit den Fremdstoffen versehenen Silizidtargets möglich.

In einer Weiterbildung der Erfindung ist vorgesehen, dass das Halbleitergebiet monokristallin auf die Silizidschicht aufgewachsen wird. Vorzugsweise wird auf die Silizidschicht monokristallines Silizium epitaktisch aufgebracht. Hierzu können vorteilhaft die Molekularstrahl-Epitaxie oder metallorganische Abscheideverfahren verwendet werden.

In einer bevorzugten Ausgestaltung der Erfindung wird monokristallines Halbleitermaterial mit einer Dicke auf die Silizidschicht aufgebracht, die die Anordnung eines aktiven Halbleiterbauelementes oberhalb der Silizidschicht ermöglicht. Vorzugsweise weist das Halbleiterbauelement pn-Übergänge innerhalb der Dicke des Halbleitermaterials auf.

Ein anderer Aspekt der Erfindung ist ein Verfahren zur Herstellung einer Anschlussbahn schichtförmigen Aufbaus mit einer Länge im Bereich zwischen einer Mindestlänge und einer Höchstlänge, welche Anschlussbahn insbesondere aus einer Siliziumschicht und einer Silizidschicht besteht, indem
- eine Siliziumschicht mit einer Dotierstoffkonzentration N_{BL} bereitgestellt wird,
- eine der Siliziumschicht unter- oder aufliegenden Schicht aus einem mit einem oder mehreren Fremdstoffen versehenen Silizid bereitgestellt wird, wobei die Fremdstoffe in einem angrenzenden Halbleitermaterial als Dotierstoffe wirken,
- ein Teil des einen oder der mehreren Fremdstoffe aus der Silizidschicht in die Siliziumschicht durch Temperaturbehandlung ausdiffundiert wird,
wobei
- die Dotierstoffe als Dotanden für Silizium fungieren,
- die Schichtüberlappung eine Höchstlänge, gemessen in Mikrometern, von 2e20 geteilt durch die Dotierstoffkonzentration N_{BL} in cm⁻³ nicht überschreitet.
Vorzugsweise weist die Schichtüberlappung eines Mindestlänge von 1 µm auf.

Durch das hier angegebene Herstellungsverfahren lässt sich die Oberflächenkonzentration in der kontaktierten Siliziumschicht am Übergang zur kontaktierenden Silizidbahn für niedrigdotierte kontaktierte Siliziumschichten deutlich über die Dotierstoffkonzentration im Inneren der kontaktierten Siliziumschicht erhöhen, und so der Kontaktwiderstand senken.

Ein weiterer Aspekt der Erfindung betrifft einen Halbleitergegenstand mit einer vergrabenen Silizidschicht, die an ein monokristallines Halbleitergebiet angrenzt. Dabei ist das monokristalline Halbleitergebiet durch Dotanden dotiert, die aus der als Dotierstoffquelle wirkenden Silizidschicht ausdiffundiert sind.

Bevorzugt ist ein Übergangswiderstand zwischen dem monokristallinen Halbleitergebiet und der Silizidschicht ohmsch ausgeprägt, wobei der Übergangswiderstand vorzugsweise weniger als 1 mOhm cm² , besonders bevorzugt von weniger als 0,1 mOhm cm² aufweist.

Eine bevorzugte Weiterbildung der Erfindung sieht vor, dass die Silizidschicht durch das monokristalline Halbleitermaterial zumindest teilweise bedeckt ist, dass vorzugsweise der niedrigste Übergangswiderstand zwischen der Silizidschicht und dem aufliegenden Halbleitermaterial ausgebildet ist.

Die Erfindung weiterbildend ist vorgesehen, dass die Silizidschicht durch Halbleitermaterial des Halbleitergebiets zumindest teilweise monokristallin überwachsen ist, wobei vorzugsweise das Gitter der Silizidschicht durch das Gitter des Halbleitergebietes fortgesetzt wird.

Vorzugsweise ist das Halbleitergebiet ein Teil eines aktiven Bauelementes. Um einen Strom über den Übergangswiderstand zwischen der Silizidschicht und dem monokristallinen Halbleitergebiet fließen zu lassen, ist die Silizidschicht vorteilhafterweise entfernt von der Grenzfläche zu dem monokristallinen Halbleitergebiet an einen metallischen Kontakt angeschlossen.

Ein anderer Aspekt der Erfindung ist eine Verwendung eines zuvor beschriebenen Herstellungsverfahrens zur Ausbildung eines Hochfrequenzbauelementes oder eines Hochvoltbauelementes mit einem durch eine Silizidschicht niederohmig angeschlossenen, aktiven Halbleitergebiet.

Ein weiterer Aspekt der Erfindung ist ein Hochfrequenzbipolartransistor mit einem Emitterhalbleitergebiet, einem Basishalbleitergebiet und einem Kollektorhalbleitergebiet. Das Kollektorhalbleitergebiet grenzt an eine Silizidschicht an, die zumindest teilweise unterhalb des Kollektorhalbleitergebiets vergraben ist. Der an die Silizidschicht angrenzende Bereich des Kollektorhalbleitergebiets ist durch Dotanden hoch dotiert, die aus der Silizidschicht ausdiffundiert sind.

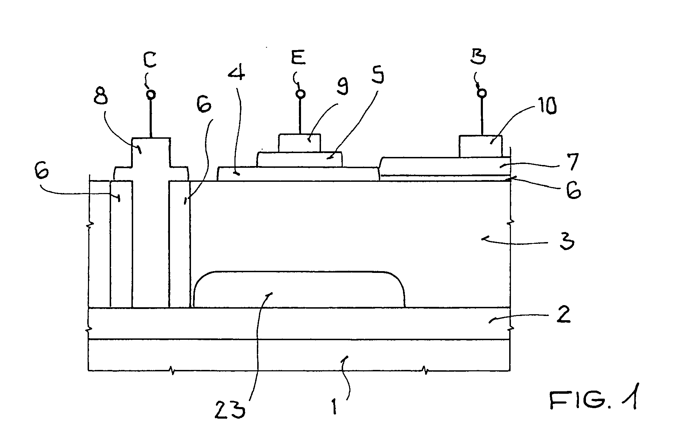

Die Erfindung wird durch ein Ausführungsbeispiel anhand einer zeichnerischen Darstellung näher erläutert. Dabei zeigt die Figur eine schematische Darstellung eines Halbleitergegenstandes, der einen Bipolartransistor bildet.

Der Bahnwiderstand enthält neben einem Schichtwiderstand eines vergrabenen Silizidbereichs einen Übergangswiderstand zwischen dem vergrabenen Silizidbereich und einem angrenzenden monokristallinen Halbleiterbereich, der als aktives Gebiet eines Bauelementes dienen soll. Der Übergang vom vergrabenen Silizidbereich zu dem monokristallinen Halbleiterbereich ist hierbei bei niedrigen und gemäßigt hohen Dotandenkonzentration im monokristallinen Halbleiterbereich an der Grenzfläche zum vergrabenen Silizidbereich als hochohmiger, sogenannter Schottky-Kontakt, ausgebildet. Lediglich bei hohen bis sehr hohen Dotandenkonzentration ist der Kontakt vom niederresistiven, sogenannten Ohm'schen Typ.

Es ist nun, aufgrund der Ausdiffusion aus hochdotierten Halbleiterbereichen bei Temperaturbeaufschlagung, nicht immer erwünscht, den monokristallinen Halbleiterbereich bereits bei dessen Aufbringung mit einer hoher Dotierstoffkonzentration an der Grenze zur vergrabenen Silizidschicht zu versehen. Im dies zu ermöglichen wird anhand der Figur ein Ausführungsbeispiel eines Herstellungsverfahrens angegeben. Dieses hat den Vorteil, das es nicht notwendig ist nachträglich durch Implantation eine hohe Dotandenkonzentration im monokristallinen Halbleiterbereich an der Grenzfläche zum vergrabenen Silizidbereich zu erzeugen. Auch wird die nachteilige relativ breite, gauss'sche Streuung von Dotanden, die durch die tiefe Implantation eingebracht werden, vermieden.

Ausgehend von der Oberfläche des Wafers liegt das Substrat 1 zu unterst, wobei das Substrat aus monokristallinem Halbleitermaterial, beispielsweise aus Silizium oder aus einem Isolator bestehen kann. Auf dieses Substrat 1 ist eine Silizidschicht 2, beispielsweise Titansilizid, Tantalsilizid, Cobaltsilizid oder Wolframsilizid beispielsweise durch Sputtern eines Silizidtargets aufgebracht.

In einem Herstellungsverfahren wird diese Silizidschicht als Dotierstoffquelle für nachfolgende Verfahrensschritte ausgebildet, indem in diese Silizidschicht 2 vor dem Aufbringen von weiteren Schichten (über diese Silizidschicht 2) eine hohe Dosis von Fremdstoffen implantiert, die in einem angrenzenden Halbleitergebiet als Dotanden, eines ersten Leitungstyps, beispielsweise eines n-Leitungstyps dienen können.

Durch das nachfolgende Aufbringen einer monokristallinen Siliziumhalbleiterschicht 3, die ebenfalls vom ersten Leitungstyps ist, wird die Silizidschicht 2 vergraben. Um die Silizidschicht 2 zu kontaktieren ist eine Metallisierung 8 in eine in die monokristalline Siliziumhalbleiterschicht 3 geätzte Öffnung eingebracht. Um die Metallisierung von der monokristallinen Siliziumhalbleiterschicht 3 zu isolieren ist Bereich der monokristallinen Siliziumhalbleiterschicht 3 mit einem thermischen Oxid 6 abgedeckt.

Während der Oxidation zur Ausbildung des thermischen Oxids 6 werden die Temperatur und die Zeitdauer der Oxidation derart ausgelegt, dass die in die Silizidschicht 2 zuvor implantierten Dotanden in die angrenzende monokristalline Siliziumhalbleiterschicht 3 eindiffundieren und dort einen niederohmigen Übergangswiderstand zwischen der monokristallinen Siliziumhalbleiterschicht 3 und der Silizidschicht 2 bewirken. Hierzu diffundieren die Dotanden in einen für den Übergangswiderstand maßgeblichen Grenzbereich 23, der an die Silizidschicht 2 angrenzt derart ein, dass dieser Grenzbereich 23 eine maximale Dotierstoffkonzentration von mindestens 1 · 10²⁰cm⁻³ aufweist.

Nachfolgend wird eine SiGe-Halbleiterschicht 4 eines zweiten Leitungstyps (p-leitend) aufgebracht. Diese grenzt an eine Silizidschicht 7 aus TiSi₂ an, die wiederum an eine Metallisierung 10 grenzt. In die nicht-vergrabene Silizidschicht 7 sind ebenfalls Dotanden des zweiten Leitungstyps eingebracht, die in die SiGe-Halbleiterschicht 4 während einer thermischen Beaufschlagung eindiffundieren. Auf die SiGe Halbleiterschicht 4 ist wiederum eine Siliziumhalbleiterschicht 5 des ersten Leitungstyps aufgebracht, die mittels einer Metallisierung 9 kontaktiert ist. Die Metallisierung 8, 9 und 10 bilden dabei den Kollektoranschluss C, den Emitteranschluss E und den Basisanschluss B respektive. Das dargstellte Ausführungsbeispiels der Figur zeigt mit den angegebenen Leitungstypen beispielhaft einen npn-Hochfrequenzbipolartransistor.

Vorteilhaft an diesem Ausführungsbeispiel ist, dass ein Fremdstoff in die vergrabene Silizidschicht 2 oder in Teile der vergrabenen Silizidschicht 2 eingebracht wird, welcher bei thermischer Beaufschlagung in den an die Silizidschicht 2 angrenzenden Halbleiterbereich 23 eindiffundiert und dort als Dotierstoff wirkt. Hierdurch wird ermöglicht, den Anschlusswiderstand zu reduzieren. Der Anschlusswiderstand weist dabei die wesentlichen Anteile eines Leitungswiderstands der Silizidschicht 2 und eines Übergangswiderstandes zwischen der monokristallinen Halbleiterschicht 3 und der Silizidschicht 2 auf. Um den Übergangswiderstand zwischen der monokristallinen Halbleiterschicht 3 und der Silizidschicht 2 in den niederresistiven, ohmschen Bereich zu bringen, wird durch das Ausführungsbeispiel der Figur an der Grenzfläche zwischen der Silizidschicht 2 und dem angrenzenden Halbleiterbereich 23 eine Dotierstoffkonzentration größer als 1 . 10²⁰cm⁻³ erreicht. Dabei wird eine geringe laterale Ausdiffusion der Dotanden erzielt, indem das thermische Budget durch dieses beschriebene Verfahren insgesamt verhältnismäßig klein gehalten werden kann.

## Patentansprüche

1. Verfahren zur Herstellung eines Halbleitergegenstandes, indem
- eine Silizidschicht (2) aufgebracht wird,
- in die Silizidschicht (2) ein Fremdstoff eingebracht wird, der in einem Halbleitergebiet (3) als Dotand wirkt,
- die Silizidschicht (2) zumindest teilweise unterhalb des, an die Silizidschicht angrenzenden, monokristallinen Halbleitergebietes (3) angeordnet wird, so dass die Silizidschicht (2) unter einer Schicht aus dem monokristallinen Halbleitergebiet (3) zumindest teilweise vergraben wird,
und
- mittels eines späteren Hochtemperaturschrittes der als Dotand wirkende Fremdstoff zumindest teilweise in das angrenzende monokristalline Halbleitergebiet (3) aus der zumindest teilweise vergrabenen Silizidschicht (2) eindiffundiert wird.

2. Verfahren nach Anspruch 1,
**dadurch gekennzeichnet, dass**
- das monokristalline Halbleitergebiet (3) strukturiert wird,
- mit dem Aufbringen der Silizidschicht zumindest ein Bereich der Silizidschicht (2) unter das zuvor strukturierte, monokristalline Halbleitergebiet (3) eingebracht wird, und
- in dem späteren Hochtemperaturschritt der als Dotand wirkende Fremdstoff in das angrenzende, strukturierte monokristalline Halbleitergebiet (3) aus der Silizidschicht (2) eindiffundiert wird.

3. Verfahren nach Anspruch 1,
**dadurch gekennzeichnet, dass**
- die aufgebrachte Silizidschicht (2) zumindest teilweise durch das nachfolgend aufgebrachte, monokristalline Halbleitergebiet (3) derart bedeckt wird, dass die Silizidschicht (2) unter einer Schicht aus dem monokristallinen Halbleitergebiet (3) zumindest teilweise vergraben wird, und
- in dem späteren Hochtemperaturschritt der als Dotand wirkende Fremdstoff zumindest teilweise in das bedeckende, monokristalline Halbleitergebiet (3) aus der Silizidschicht (2) eindiffundiert wird.

4. Verfahren nach einem der vorhergehenden Ansprüche,
**dadurch gekennzeichnet, dass**
in einem an die Silizidschicht (2) angrenzenden Grenzbereich (23) des monokristallinen Halbleitergebiets (3) der als Dotanden wirkende Fremdstoff derart eindiffundiert wird, dass ein Übergangswiderstand zwischen dem monokristallinen Halbleitergebiet (3) und der Silizidschicht (2) ohmsch ausgebildet wird.

5. Verfahren nach Anspruch 4,
**dadurch gekennzeichnet, dass**
in das für den Übergangswiderstand wirksame Grenzgebiet (23) eine Dotierstoffkonzentration von mindestens 1 · 10²⁰cm⁻³ eindiffundiert wird.

6. Verfahren nach einem der vorhergehenden Ansprüche,
**dadurch gekennzeichnet, dass**
der Fremdstoff in die Silizidschicht (2) implantiert wird.

7. Verfahren nach einem der Ansprüche 1 bis 5,
**dadurch gekennzeichnet, dass**
das Einbringen des Fremdstoffs und das Aufbringen der Silizidschicht (2) mittels gleichzeitigem Sputtern eines Dotierstofftargets und eines Silizidtargets erfolgen.

8. Verfahren nach einem der Ansprüche 1 bis 5,
**dadurch gekennzeichnet, dass**
das Einbringen des Fremdstoffs und das Aufbringen der Silizidschicht (2) mittels Sputtern eines mit dem Fremdstoff versehenen Silizidtargets erfolgen.

9. Verfahren nach einem der vorhergehenden Ansprüche,
**dadurch gekennzeichnet, dass**
das Halbleitergebiet (3) monokristallin auf die Silizidschicht (2) aufgewachsen wird.

10. Verfahren nach einem der vorhergehenden Ansprüche,
**dadurch gekennzeichnet, dass**
auf die Silizidschicht (2) monokristallines Silizium (3) epitaktisch aufgebracht wird.

11. Verfahren nach Anspruch 10,
**dadurch gekennzeichnet, dass**
monokristallines Silizium (3) mit einer Dicke von mindestens 0,1 µm aufgebracht wird.

12. Verfahren insbesondere nach einem der vorhergehenden Ansprüche, zur Herstellung einer Anschlussbahn schichtförmigen Aufbaus mit einer Länge im Bereich zwischen einer Mindestlänge und einer Höchstlänge, welche Anschlussbahn eine Siliziumschicht und eine Silizidschicht aufweist, indem
- eine Siliziumschicht mit einer Dotierstoffkonzentration N_{BL} bereitgestellt wird,
- eine der Siliziumschicht unter- oder aufliegenden Schicht aus einem mit einem Fremdstoff versehenen Silizid bereitgestellt wird, wobei der Fremdstoff in der angrenzenden Siliziumschicht als Dotand wirkt,
- ein Teil des Fremdstoffs aus der Silizidschicht in die Siliziumschicht durch Temperaturbehandlung ausdiffundiert wird,
wobei
- der Fremdstoff als Dotand für angrenzendes Silizium fungiert,
- die Schichtüberlappung eine Höchstlänge, gemessen in Mikrometern, von 2e20 geteilt durch die Dotierstoffkonzentration N_{BL} in cm⁻³ nicht überschreitet.

13. Verfahren nach Anspruch 12,
**dadurch gekennzeichnet, dass**
die Schichtüberlappung eines Mindestlänge von 1 µm aufweist.

14. Verwendung einer zumindest teilweise unter einem monokristallinen Halbleiterbereich angeordneten Silizidschicht (2), die mit einem Fremdstoff versehen ist, als Festkörperquelle für die Dotierung zumindest des oberhalb der Silizidschicht (2) angeordneten Halbleiterbereichs (3) in einem Verfahren zur Herstellung eines Halbleitergegenstandes, vorzugsweise nach einem der vorhergehenden Ansprüche, wobei der aus der Silizidschicht (2) ausdiffundierende Fremdstoff in angrenzenden Halbleiterbereichen (3) als Dotierstoff wirkt.

15. Halbleitergegenstand mit einer vergrabenen Silizidschicht (2), die an ein monokristallines Halbleitergebiet (3) angrenzt,
**dadurch gekennzeichnet, dass**
das monokristalline Halbleitergebiet (3) durch einen Dotierstoff dotiert ist, der aus der als Dotierstoffquelle wirkenden, vergrabenen Silizidschicht (2) ausdiffundiert ist.

16. Halbleitergegenstand nach Anspruch 14,
**dadurch gekennzeichnet, dass**
ein Übergangswiderstand zwischen dem monokristallinen Halbleitergebiet (3) und der Silizidschicht (2) ohmsch ausgeprägt ist.

17. Halbleitergegenstand nach Anspruch 16,
**dadurch gekennzeichnet, dass**
der Übergangswiderstand weniger als 1mOhm cm² beträgt.

18. Halbleitergegenstand nach einem der Ansprüche 14 bis 17,
**dadurch gekennzeichnet, dass**
die Silizidschicht (2) durch das monokristalline Halbleitermaterial (3) zumindest teilweise bedeckt ist.

19. Halbleitergegenstand nach Anspruch 18,
**dadurch gekennzeichnet, dass**
die Silizidschicht (2) durch Halbleitermaterial des Halbleitergebietes (3) zumindest teilweise monokristallin, das Gitter der Silizidschicht (2) fortsetzend überwachsen ist.

20. Halbleitergegenstand nach einem der Ansprüche 3 bis 19,
**dadurch gekennzeichnet, dass**
das Halbleitergebiet (3) ein Teil eines aktiven Bauelementes ist.

21. Halbleitergegenstand nach einem der Ansprüche 14 bis 20,
**dadurch gekennzeichnet, dass**
die Silizidschicht (2) an einen metallischen Kontakt (8) angeschlossen ist.

22. Verwendung eines Herstellungsverfahrens nach einem der Ansprüche 1 bis 10 zur Ausbildung eines Hochfrequenzbauelementes mit einem durch eine Silizidschicht (2) niederohmig angeschlossenen, aktiven Halbleitergebiet (3).

23. Verwendung eines Herstellungsverfahrens nach einem der Ansprüche 1 bis 10 zur Ausbildung eines Hochvoltbauelementes mit einem durch eine Silizidschicht (2) niederohmig angeschlossenen, aktiven Halbleitergebiet (3).

24. Hochfrequenzbipolartransistor mit
- einem Emitterhalbleitergebiet (5),
- einem Basishalbleitergebiet (4) und
- einem Kollektorhalbleitergebiet (3),
wobei
- das Kollektorhalbleitergebiet (3) an eine Silizidschicht (2) angrenzt, die zumindest teilweise unterhalb des Kollektorhalbleitergebiets (3) vergraben ist,
- der an die Silizidschicht (2) angrenzende Bereich (23) des Kollektorhalbleitergebiets (3) durch einen Dotierstoff dotiert ist, der aus der Silizidschicht (2) ausdiffundiert ist.
